# EUROPEAN PATENT APPLICATION

(11) **EP 1 420 625 A2**
(43) Date of publication of application: **19.05.2004**
(21) Application number: 03292725.3
(22) Date of filing: 31.10.2003
(51) Int. Cl.: H05K 9/00

(54) **Shield casing with heat sink for electric circuit**

(30) Priority: 12.11.2002 EP 02292807
(71) Applicant: Thomson Licensing S.A., 92100 Boulogne-Billancourt (FR)
(72) Inventor: Lum, Lye Yoong, 552142 Singapore (SG); Toh, Ching Hua, 640466 Singapore (SG)
(74) Representative: Rossmanith, Manfred, Dr.

(57) **Abstract**

A casing for electric circuits is proposed, which shields the circuits from EMI phenomena. The circuit has means for making thermal contact with heat generating components inside the casing, allowing using the casing as a heat sink to dissipate the heat. The casing comprises a frame, a cover and an inwardly projecting element for thermally contacting a heat source within the casing. The inwardly projecting element is designed so as not to cause any openings in the casing. The inwardly projecting element may be an integral part of the frame or the cover and all parts of the casing may advantageously be produced using cut-and-bend procedures.

## Description

### Field of the invention

The present invention concerns casings for electric or electronic circuits, which are used for the circuits from electromagnetic interference. This type of casing is often also referred to as shield casing.

### Background information

Electric and electronic circuits are often subject to electromagnetic interference caused by other circuits in the vicinity, nearby conductors carrying high frequency signals or large currents, or other sources. Electromagnetic interference is commonly known under its acronym EMI and comprises electromagnetic radiation as well as static discharges and other phenomena, which may influence electric and electronic circuits. Electromagnetic interference of any kind is generally referred to hereinafter as EMI. EMI differently affects and influences different types of circuits or components. Especially, circuits for receiving high frequency signals having low signal levels are subject to EMI. To avoid problems due to this interference, the circuitry most susceptible to EMI is often mounted inside of casings made from electromagnetic shielding material. For proper operation the casing must not, e.g., have openings larger than the smallest expected wavelength of an interfering electromagnetic wave. The operating principle of shield casings of this type is to convert the energy of the electromagnetic wave into eddy currents flowing in the casing and finally convert the eddy currents into heat. The material of the shield casing preferably has a high electric conductivity and a low magnetic permeability. To improve the shield effect of the casing and to reduce detrimental effects due to capacitive coupling, the shield casing is generally connected to a low impedance circuit ground. For this purpose, the shield casing has projecting elements, which snugly fit into corresponding openings in a circuit carrier, e.g., a printed circuit board. The casing is then soldered to the circuit carrier, connecting the casing electrically conducting to the circuit ground.

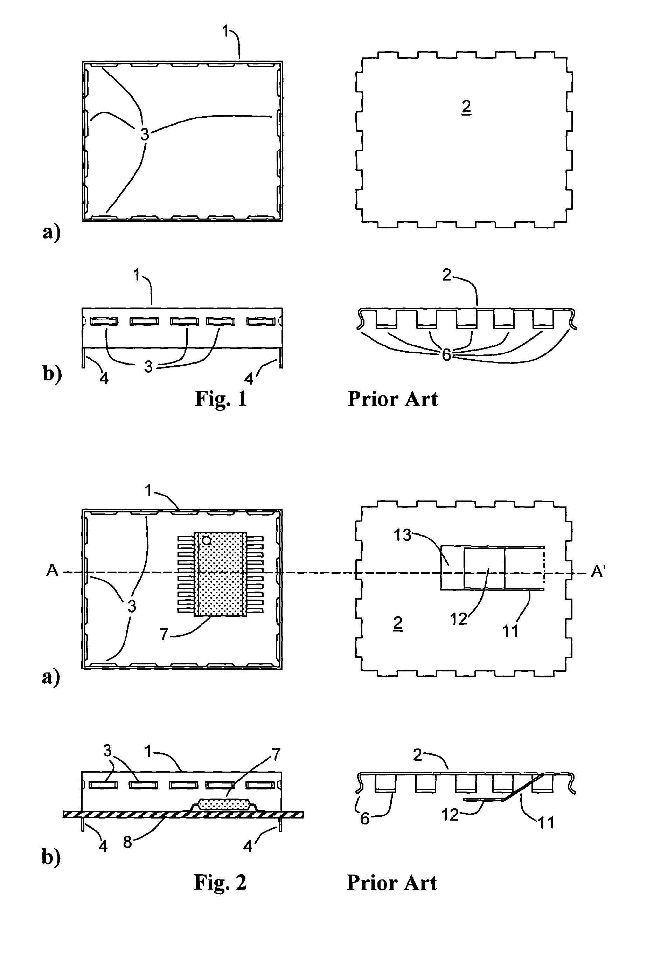

Common shield casings generally consist of a frame, determining the space to be shielded, and a lid, or cover, which is fastened electrically conducting to the frame. A shield casing as mentioned above is shown exemplarily in Fig. 1 of the drawing.

Fig. 1a) shows, on its left side, a top view of a frame 1 and, on its right side, a lid 2 of a common shield casing according to the prior art. The frame 1 carries depressed parts 3 along its circumference, only few of which are referenced by a reference symbol for the sake of clarity. Fig. 1b) shows a side view of the shield casing's components according to the prior art. Again, the frame 1 is shown on the left side of the figure. The depressed parts 3 of the frame 1 serve as an engaging element for corresponding engaging elements of the lid 2. The frame 1 further has projecting elements 4, which serve for mounting the frame electrically conducting to a circuit carrier (not shown). The lid 2 shown on the right side of Fig. 1b) has resilient clamps 6 along its outer boundary, which are formed so as to engage with the corresponding depressed parts 3 of the frame 1. When the lid 2 is correctly mounted to the frame 1, the depressed parts 3 of the frame 1 and the resilient clamps 6 of the lid 2 ensure proper electrical and mechanical contact. In another embodiment, which is not shown in Fig. 1, the depressed parts 3 of the frame 1 are projecting out of the frame 1, similarly engaging with corresponding resilient clamps 6 of a lid 2. Both of these methods along with other methods of fixing a lid 2 to a frame 1 of a shield casing are in the following considered equivalent and no distinction is made between them.

A correctly assembled shield casing as described above with reference to Fig. 1 has no large openings, thus preventing electromagnetic waves or other EMI phenomena from influencing the circuitry contained in the shielded space inside the casing. However, the circuitry inside the shield casing, especially active semiconductor components, may generate considerable heat, which has to be dissipated in order not to exceed the maximum allowable operating temperature of the respective components. As mostly the shield casings are rather small, surrounding only few components of a complex system, convection does not contribute much to heat transfer and dissipation. Generally, the components inside of the shield casings do not have defined and reliable thermal contact with any part of the casing. This is largely reducing the effect of direct heat transportation in solid matters, which is one of the most efficient ways to remove heat from a heat source via a heat sink. Dissipation of heat via radiation is generally far less effective than the other methods of heat transport mentioned above. As a result, the temperature of components inside properly closed shield casings may reach unwanted or even detrimental levels.

In order to overcome the problems of excessive heat inside of shield casings, attempts were made to establish a solid contact between a heat source inside of the casing and the casing itself, thus using the casing as a heat sink. Fig. 2 shows an exemplary shield casing with improved heat removal via a thermal conductor, which is brought into contact with heat generating components inside of the casing. Fig. 2a) shows on its left side a frame 1 and on its right side a lid 2. In the frame 1 a heat source 7 is placed, represented by a schematic view of an integrated circuit. A part of the lid 2 shown on the right side of Fig. 2a) is used as a thermal conductor 11, contacting the heat source 7 inside the shield casing once the casing is assembled properly. In order to do so, the thermal conductor 11 is partly cut free from the lid 2 and bent inwards. Fig. 2b) shows a side view of the frame 1 on its left side and the lid 2 on its right side, cut along the sectional line A-A'. The frame 1 is substantially the same as in Fig. 1. The frame 1 is mounted to a circuit carrier 8 by means of the projecting elements 4, and the circuit carrier 8 carries the heat source 7. The lid 2 is similar to the lid 2 in Fig. 1b) but additionally carries the cut-and-bent thermal conductor 11. Once assembled, the contact area 12 of the thermal conductor 11 comes into contact with the corresponding area of the heat source 7 inside the shield casing. In order to improve the thermal conducting contact between the contact area 12 and the heat-generating component, heat-conducting agents may be used. By cutting and bending the heat-conducting element 11, an opening 13 in the shield casing is created, allowing electromagnetic waves or other EMI phenomena to influence components contained within the shielded space and reducing the shielding effect.

It is an object of the invention to solve the problem of excessive temperature of components in substantially closed casings, especially shield casings.

### Description of the invention

To achieve this object a shield casing is suggested having no unwanted openings, thus providing good shielding against EMI phenomena, and having means for thermally contacting heat generating components inside the casing, using the casing as a heat sink to dissipate heat. The suggested shield casing consists of at least a frame, a cover and an inwardly projecting element for thermally contacting a heat source within the casing, according to claim 1. The inwardly projecting element is designed so as not to cause any unwanted openings in the casing. Advantageous embodiments of the invention are disclosed in the sub claims.

According to the invention, the shield casing has an element projecting inwards into the space confined by a frame and a lid, the element contacting a heat source inside the casing and serving as a thermal conductor. In a preferred embodiment the inwardly projecting element is attached to the frame near the top rim of the frame. It is, however, possible that the inwardly projecting element is attached to the lower rim of the frame. Depending on the number of heat-generating components inside the shield casing one or more inwardly projecting elements may be used. In a preferred embodiment the frame is a cut-and-bent part, which is produced by cutting a planar material, e.g., sheet metal, and bending the cut piece into its desired three-dimensional form. In this way the frame can be produced from one single piece. It is, however, possible to produce the frame using other techniques, such as die casting, or to assemble the frame from multiple parts using soldering or welding techniques, riveting or interlocking parts, a method also known to the public as snap-together. The inwardly projecting element is bent in a way, that a plane surface of the element resiliently contacts a corresponding surface of a heat source inside the casing. The heat transfer may be improved by using heat-conducting agents. A completely closed lid is fastened removable to the frame, closing the shield casing. The lid and the frame may have interlocking structures to improve the electrical and mechanical contact between the frame and the lid. The interlocking elements of the frame and the lid are known from the prior art and are not described in detail. It is, however, also possible to fasten the lid to the frame using screws, bolts, or similar means, or to solder or weld the parts together. In one embodiment, in order to improve the contact between the inwardly projecting element and the heat source, a free end of the element is resiliently bent towards the lid, such that the correctly placed lid applies an additional force on the element, advantageously improving the heat transfer by pressing the contact area of the element against the corresponding contact area of the heat source. In another embodiment the inwardly projecting element has two or more contact areas for contacting two or more heat sources inside the casing. In this case the inwardly projecting element is bent towards the lid between the individual contact areas, thereby improving the thermal contact of each individual contact area by applying a force pressing the contact areas onto the corresponding surfaces of the heat sources. The invention is not limited to inwardly projecting elements being attached to the frame. In another embodiment, the element serving as a thermal conductor is attached to the lid. In this case, the thermal conductor is first bent so as to form a resilient clamp fastening the lid from the inside rather than from the outside. The free end of the clamp is then used to form the heat conductor, which is brought into contact with the heat source.

### Brief description of the drawing

For a better understanding the invention is described in the following with reference to the drawing. In the drawing
- Fig. 1: shows a shield casing according to the prior art,
- Fig. 2: shows another shield casing according to the prior art,
- Fig. 3: shows a first embodiment of a shield casing according to the invention,
- Fig. 4: shows a second embodiment of a shield casing according to the invention, and
- Fig. 5: shows a third embodiment of a shield casing according to the invention.

In the drawing, identical or similar elements are referenced with identical reference symbols.

Figs. 1 and 2 have already been described in detail in the prior art section and will therefore not be described again.

### Description of the preferred embodiment

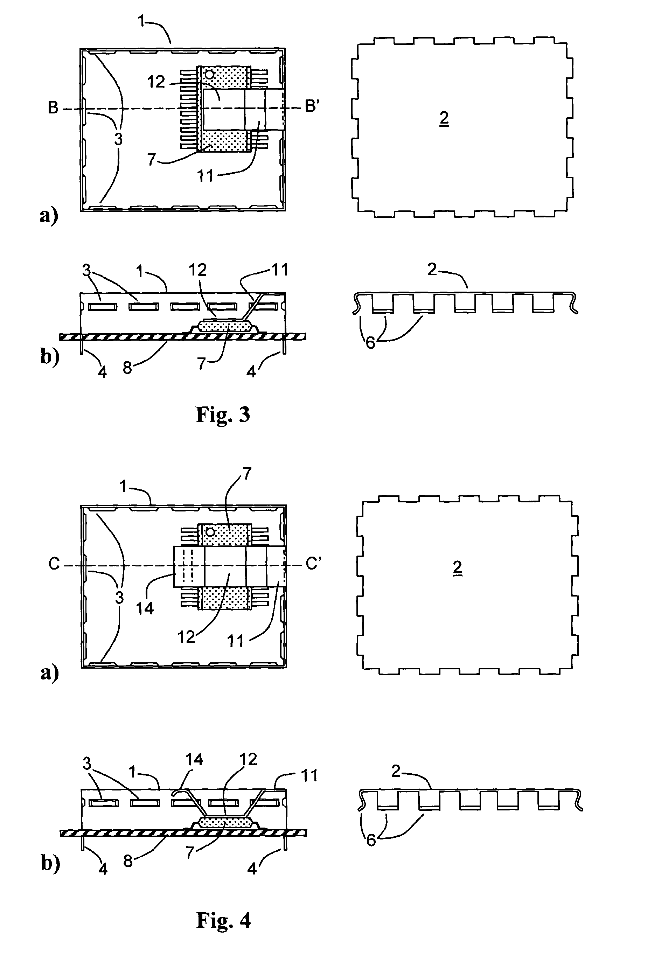

Fig. 3 shows a first embodiment of a shield casing according to the invention. The left side of Fig. 3a) shows a top view of a frame 1 with a thermal conductor 11. A heat source 7 is represented by a schematic view of an integrated circuit. An area of contact 12 of the thermal conductor 11 thermally contacts a corresponding surface of the heat source 7. Depressed parts 3 are arranged along the circumference of the frame, serving as engaging elements for corresponding parts of a lid. The right side of Fig. 3a) shows a top view of a lid 2, which obviously has no openings caused by a thermal conductor, thus ensuring proper shielding when mounted to the frame 1. Fig. 3b) shows in its left side a side view of the frame 1 cut along a section line B-B' shown in Fig. 3a). The frame 1 is mounted to a circuit carrier 8, which carries the heat source 7, by means of projecting elements 4. The thermal conductor 11 is bent inwards from the top right rim of the frame 1. The thermal conductor 11 is bent in a way, such that its contact area 12 contacts a corresponding surface of the heat source 7. The right side of Fig. 3b) shows a side view of the lid 2 and the resilient clamps 6, which engage with the depressed parts 3 of the frame when the lid 2 is mounted. From Figs. 3a) and 3b) it is easy to be seen that no unwanted openings in the frame 1 or the lid 2 are present caused by the forming of the thermal conductor 11. During manufacturing, the heat source 7 is placed and soldered first, before the frame 1 is mounted. When mounting the frame 1, the thermal contact 11 may be bent towards the heat source 7 more than necessary, thus forming a kind of spring loaded part, improving the contact between the heat source 7 and the thermal conductor 11.

Fig. 4 shows a second embodiment of a shield frame according to the invention. On the left side of Fig. 4a) a top view of a frame 1 is shown. As previously described in Fig. 3, the frame bears a thermal conductor 11, attached to the upper right rim of the frame 1. The thermal conductor 11 has an area of contact 12 for contacting a corresponding surface of a heat source 7. The heat source 7 is represented by a schematic view of an integrated circuit. The free end or support section 14 of the thermal conductor 11 is bent towards a lid 2, which is shown on the right side of Fig. 4a), and the correctly placed lid 2 applies a force on the support section 14, increasing the pressure between the area of contact 12 and the corresponding surface of the heat source 7. Like before, depressed parts 3 serve as an interlocking element for securing the lid 2. The lid 2 is essentially of the same kind as the one described in Fig. 3. The function of the support section 14 of thermal conductor 11 is easier understood when looking at the side view of the frame, which is presented in Fig. 4b). On the left side of Fig. 4b) a side view of the frame 1 is shown, cut along a section line C-C'. The frame 1 is mounted to a circuit carrier 8 by means of projecting elements 4. The circuit carrier 8 carries the heat source 7. The thermal conductor 11 bends inwards from the upper right rim of the frame 1 and downwards towards the heat source 7. The area of contact 12 of the thermal conductor 11 contacts a corresponding surface of the heat source 7 and the thermal conductor 11 then bends upward again towards the upper side of the frame 1, forming the support section 14. The lid 2, which is shown on the right side of Fig. 4b), when correctly placed on the frame 1, applies a pressure on the support section 14, increasing the pressure between the area of contact 12 and the corresponding surface of the heat source 7. Depressed parts 3 on the frame 1 and resilient clamps 6 on the lid 2 ensure proper mechanical and electrical contact of the parts of the shield casing. This embodiment may advantageously be used when the heat source 7 is not placed close to the frame 1, since a rather long thermal conductor 11 may not ensure good contact between the thermal conductor 11 and the heat source 7 due to a certain flexibility of the material.

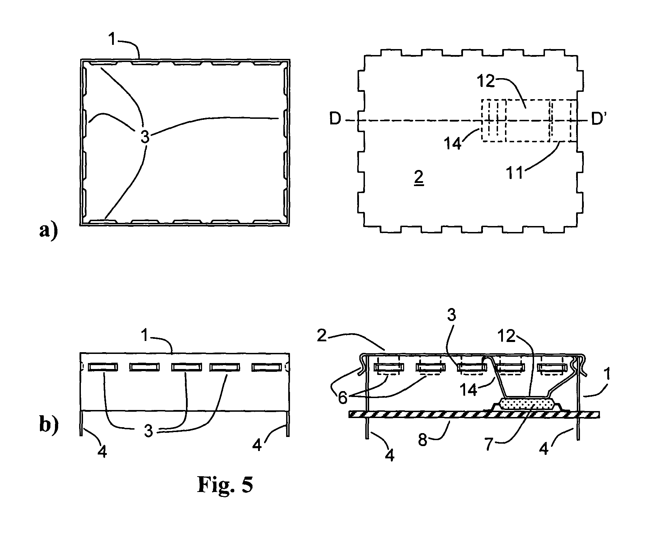

Fig. 5 shows a third embodiment of a shield casing according to the invention. Fig. 5a) shows on its left side a top view of a frame 1 with depressed parts 3 along its circumference. Like in the embodiments described before, the depressed parts 3 serve as interlocking elements for corresponding elements of a lid 2, which is shown on the right side of Fig. 5a). The lid 2 has a thermal conductor 11 attached to it on its right side. The thermal conductor 11 is bent downward underneath the lid 2 and has an area of contact 12 for contacting a corresponding surface of a heat sink. The thermal conductor further has a support section 14, which is bent upward against the lid 2 and applies an additional force on the area of contact. The function is easier to be understood taking a look at Fig. 5b). Fig. 5b) shows on its left side a side view of the frame 1 with depressed parts 3 for electrically and mechanically contacting the lid 2 and projecting elements 4 for mounting the frame to a circuit carrier 8. On its right side, Fig. 5b) shows a side view of a completely assembled shield casing cut along a section line D-D'. The frame 1 is mounted to the circuit carrier 8 with the projecting elements 4. The circuit carrier 7 carries a heat source 7. The lid 2 is fastened to the frame 1 and locked by the resilient clamps 6 engaging with the depressed parts 3. The thermal conductor 11 bends inwards into the casing from the top right edge of the lid 2. A part of the thermal conductor 11 is formed so as to form a resilient clamp pressing against the frame from the inside rather than from the outside, as do the resilient clamps 6. This ensures good electrical and mechanical contact between the lid 2 and the frame 1 in the area of the inwardly bending thermal conductor 11, too, thereby maintaining an almost entirely closed shield casing and thus good shielding properties. The thermal conductor further has an area of contact 12 for contacting a corresponding surface of the heat source 7. A further section of the thermal conductor 11 is bent upward against the lid 2, forming a support section 14. This ensures application of an evenly distributed pressure between the area of contact 12 and the heat source 7.

In all the embodiments described above it is of course possible to employ heat conducting agents to improve the thermal contact between the thermal conductor 11 and the heat source. It is also possible to form multiple areas of contact within one thermal conductor 11. This may be accompanied by corresponding support sections between these multiple areas of contact 12. It is also possible to omit the support section 14 of a thermal conductor 11, if the requirements as to pressure force are less stringent. The frame 1 or the lid 2 may have more than one thermal conductor 11, and different forms of thermal conductors, being part of either the frame 1 or the lid 2, may be used in parallel in one single shield casing. Any combination of the embodiments described above is therefore considered to be encompassed by the invention. The invention is also not limited to shield casings shielding against EMI phenomena, it may also be used in closed casings designed for conserving vacua or preventing gases or liquids to enter the space inside the casing.

## Claims

1. Casing for shielding electric circuits from electromagnetic radiation comprising a frame and a cover, which is fastened on the frame, **characterized in that** the casing comprises an element projecting inwards into the space confined by the casing, making thermal contact with a heat source within the casing and **in that** the casing substantially has no openings.

2. Casing according to claim 1, **characterized in that** the inwardly projecting element is part of the frame or the cover.

3. Casing according to claim 2, **characterized in that** the inwardly projecting element and the frame or the cover is a single part.

4. Casing according to any of the claims 1 to 3, **characterized in that** the inwardly projecting element is resilient.

5. Casing according to any of the claims 1 to 4, **characterized in that** the frame and/or the cover is a cut-and-bent part.

6. Casing according to any of the claims 1 to 4, **characterized in that** the frame and/or the cover is a cast part.

7. Casing according to any of the preceding claims 1 to 6, **characterized in that** the cover is fastened on the frame by means of resilient clamps in operative connection with the frame.

8. Casing according to claim 7, **characterized in that** the frame has structures to lock with the resilient clamps.

9. Casing according to any of the preceding claims 1 to 8, **characterized in that** a free end of the inwardly projecting element outside of an area of contact with the heat source resiliently bends towards the cover, and that the cover mounted on the frame applies a force to the free end thereby pressing the area of contact of the element onto the heat source.

10. Casing according to claim 9, **characterized in that** the inwardly projecting element has multiple areas of contact with heat sources and bends resiliently towards the mounted cover outside of an area of contact with a heat source, and that the cover applies a force to the portions bent towards it, thereby pressing the areas of contact of the element onto the heat sources.
